# EUROPEAN PATENT SPECIFICATION

(11) **EP 0 963 147 B1**
(45) Date of publication and mention of the grant of the patent: **04.12.2002**
(21) Application number: 99110692.3
(22) Date of filing: 02.06.1999
(51) Int. Cl.: H05K 9/00, H01R 9/05

(54) **Cable clamping and draining device towards ground of currents induced on the shielding braid of cables for signal transportation**
Klammeranordnung für Signalübertragungskabel zur Erdung der geflechten Abschirmung
Bride pour câbles transmetteurs des signaux, drainant au sol les courants induits dans les blindages tressés

(30) Priority: 05.06.1998 IT MI981279
(43) Date of publication of application: 08.12.1999
(73) Proprietor: Italtel s.p.a., 20154 Milano (IT); CNX S.p.A., 67100 L'Aquila (IT)
(72) Inventor: Ronchi, Domenico, 20040 Cambiago (MI) (IT); Decima, Luigi, 20151 Milano (IT)
(74) Representative: Giustini, Delio

(56) References cited:
- WO-A-94/13033
- US-A- 5 742 003

## Description

### Technical field

The present invention relates to the fixed installations of transmission systems and more in particular to devices to establish an electric contact between a metallic shielding braiding of a cable and the metallic ground of a cabinet inside of which the cable is connected, in the opening of the cabinet where the cables cross the cabinet wall.

In telecommunication systems it is important to assure an adequate drainage towards ground of the disturbing of stray currents which, because of inductive and/or capacitive phenomena, settle on the external conductor, that is on the metallic shielding braiding of cables connected inside of metallic shielded cabinets. For this reason it is important to establish a good electric contact between the metallic shielding braiding of the cable and the metallic ground of the cabinet where cables cross the metallic wall of the cabinet, (the input of the cable into the internal shielded space of the cabinet); this is required either by the need to impede the emission of electromagnetic radiation from the circuits functioning at radio frequency located into the cabinet or to impede the electromagnetic interferences entering into the cabinet from the external environment.
When one or more shielded electric cables transporting energy or informations have to be abutted inside of a shielded practice containing appliances which are sensible to electromagnetic interferences although that in the position of abutment the metallic braiding that wrapping up the conductors is electrically connected to the metallic ground of the cabinet, the portion of the shielded cable contained inside of the cabinet may constitute a way of access for electromagnetic interferences, because of induced currents in the metallic braiding of the cable. Therefore it is important to assure an efficient drainage towards ground of these induced currents in the position where the cable penetrates inside of the shielded space of the cabinet.

### Background art

Numerous technical solutions are known to realise an adequate electric contact between the metallic braiding of a cable and the metallic ground of the cabinet in proximity of the entrance hole of the cable into the shielded space inside the cabinet.
Often these devices are some common tightening clamps using screws, tie rods or compression springs.

In the quite frequent case of a particularly large number of shielded cables connected inside of the shielded space, the numerousness imposes solutions of acceptable cost either in terms of a relatively simple realisation or the assembling and disassembling operations in case of replacements, additions or removals of cables.

Different devices have been proposed suitable to assure an efficient contacting of the metallic shielding braiding of the cable to guarantee an electric continuity with respect to the metallic ground of the cabinet in the position of the passage of the cables through the metallic shielding wall of the cabinet, and these are based on the use of special clamps in which one or more jaws transferable along a substantially right-angled shifting axis of the shielded cables, which clamp a plurality of shielded cables, from which the isolating cladding has been locally removed before uncovering the respective metallic shielding braiding.

Commonly, a certain number of shielded cables are clamped together by forcing the mobile jaws of the clamp in order to assure through the metallic structure of the clamp the electric continuity with the metallic wall of the cabinet adjacent to the opening for the passage of lift of the cables.
In the Italian patent no. 1.279.091 in the name of the same applicant, is disclosed a particularly efficient solution of this type of lock clamping and contacting of metallic shielding braiding of a big number of cables entering into a shielded space.
This solution proves to be efficient in the case of shielded cables with more conductors, typically presenting a certain compressibility and of equal diameter or not excessively different from each other, but less efficient in the case of coaxial cables presenting a poor compressibility and/or in the case of high diversity among the respective diameters of the cables.
In the US patent no. 3.830.954 another type of multiple locking and contacting clamp is described able to receive a sure number of shielded cables, characterised in that a series shaped fittings of a deformable and electrically conducting material such as for example a foam or sponge of an elastomer conductor are compressible acting on a compression bar activated by a clamping srew.
The routes of the drainage current towards the metallic ground of the cabinet may tum out to be excessively resistive especially when foams or elastomer conductors with bulk resistivity are used.

Moreover the construction of the multiple clamping system using one or more compression bars with right-angled sliding compared to the axis of the cables turns out to be rather complex and requires suitable tricks to assure a shielding covering of the complete opening applied through the metallic wall of the cabinet, as well as to guarantee electric drainage routes towards the metallic ground of the cabinet through multiple contacts that establish between the metallic shielding braiding of the cable, the packing or elastic conducting jaw, the compression bars, the sliding frame of the compression bars and between this one and the metallic wall adjacent to the opening for the passage of the cables.
WO 94 13033 in the name of the same applicant, discloses a device for shielding electrical cables abutting cabinets containing telecommunications equipment has metallic parallelepiped shaped box containing mobile slidable contact and clamping members for shielded electric cable, with cables being compressed in longitudinal direction once installed. The device comprises the metallic parallelepiped shaped box with an open side. Sliding symmetrical contact members are positioned in the clamping space to accommodate the shielded electric cables . The cables, once installed, are compressed to hold them in position by a screw and threaded flange located on a side wall of the box. The contact members include support members provided with openings with arched blocks. The blocks are moved by elastic pushing members.
Again This solution proves to be efficient in the case of shielded cables with more conductors, typically presenting a certain compressibility and of equal diameter or not excessively different from each other, but less efficient in the case of coaxial cables presenting a poor compressibility and/or in the case of high diversity among the respective diameters of the cables

### Summary of the invention

These difficulty and drawbacks of well-known systems have been overcome in an efficient way by the device according to the invention as defined in Claim 1.

In particular the device according to the invention which can be realised with a limited number of parts, is indifferently efficient either for multiconductor cables also with a relative wide diameter or for coaxial cables, may be prepared in advance to receive whatever number of cables of also very different diameters among them, and substantially does not need any plugging for the excessive or unused passage opening, if not in the case of predisposed passages for cables with a large diameter which are no more utilised.

The device according to the invention is essentially set up by at least 3 conductor plates provided with the same plurality of holes which may be aligned in a mutually coaxial way among them and with a diameter slightly larger than the diameter of the respective cables to be passed through the aligned holes of the trio or plurality of plates. The plates functionally set up part of a metallic wall which is functionally deprived of openings that may represent the waveguide for the output of electromagnetic waves from the containing cabinet.

At least one intermediate plate of the trio or the plurality of plates may be transferred necessarily with respect to the two outer plates of the set in order to carry out a strong clamping action on the cables which external isolating cladding has been stripped before in order to expose locally the metallic shielding braid, and which pass separately through respective coinciding holes of the plates.

The action of drawing into a certain direction of the plate or of more internal plates tempt to deform locally the straight layout of the cables passing through the aligned holes of the plate establishing through the edges of the cut in the plates forced against the metallic shielding braiding of the cables a good ohm contact with the same reducing at the same time the free opening either of the loose around the single cables clamped in this way or the corresponding and for the passage of cables unused holes through the plurality of plates.

In the case of passage holes with a relatively small diameter destined on purpose to the passage of coaxial cables, the presence of a number of unused holes doesn't require necessarily suitable padding to avoid the emission of electromagnetic energy from the inner of the confined space typically lodging electronic circuits to which the conductors of the coaxial cables abut, further to the limits established by the norms in force, in virtue of fact that the free opening through partially not aligned holes after the translation of the intermediate plates is such to result of dimensions which are irrelevant for the emission of electromagnetic radiation.

In case that the device is provided with holes for the passage of shielded multiconductor cables with a large diameter, these large diameter holes may maintain in seat like diaphragms the shearing disc held by two or more perimetrical bridges which may be easily interrupted. Every hole may therefore only be open when necessary to pass through the device a cable with such large diameter.

In case it will be necessary to remove one of these cables with a relatively large diameter previously connected inside the cabinet, the relative passage hole with a large diameter which are not covered sufficiently by the clamping translation of the intermediate plate, will be closed by suitable metallic lids which may be forcedly snap inserted, preferably in both holes existing in the two external plates, better terminals of the device (one turned towards the external environment and the other towards the space inside the cabinet.
The plates composing the device according to the invention may be perforated in function of needs or also in more or less standardisable, for example predisposing a certain number of holes for different types of cables among those more commonly employed in transmission systems.

The diameter of such holes is such that, when translation of said intermediate plate has happened, the maximum dimension of the virtual waveguide identified by the aforesaid holes which may be aligned in a mutually coaxial way among them, isn't superior to a pre-set entity that is function of the wavelength of the signals transiting in the appliances housed in said cabinets.

Regarding the systems used by the applicant which are suitable to handle signals used in the telecommunication field, and therefore signals presenting a predetermined wavelength range, it has been estimated that said entity is equal to 4 mm. In others words the wavelengths in question are such that the aforesaid virtual waveguide results to be not suitable to enable the transfer of electromagnetic energy if the maximum diameter of the aforesaid virtual waveguide is not superior to 4 mm.

Preferably also holes and lids or frangible diaphragms are realised for the cables with a larger diameter (for example holes with a diameter equal to 12 mm).

While in a basic embodiment the device is composed by a trio of perforated plates, the central plate of which is necessarily movable by a screwing mechanism, the device may also be realised by a greater number of plates, foreseeing however two fixed terminal plates and two or more intermediate plates of which two or more are necessarily movable with respect to the external fixed plates.

In whatever form the device according to the invention may be realised, the multiplate set closes completely a suitable opening of metallic wall of the cabinet or confinement space with the exception of possible holes with a large diameter present on the plates not requiring in this way to apply any suitable padding sheets to close parts of the opening when the clamping of holdfasts and alike devices of the already known techniques has been carried out.

Different from already known clamping systems of a number of cables between conducting holdfasts, the device according to the invention assures the realisation of a good conductive contact between the metallic shielding braid of each cable and the metallic confinement wall usually permanently connected to earth, in an individual way, cable by cable, and in substantially uniform way also between cables with different diameters, in virtue of the fact that, irrespectively from the diameter, the loose of the passage opening of the cables through the trio or the plurality of aligned holes among them is nearly identical, having foreseen holes with a diameter which is suitable for the different cable diameters which may be handled with the device according to the invention.

### Brief description of the drawings

The different aspects and advantages of the invention will become more evident through the following description of some embodiments and referring to the enclosed drawings, in which:
Fig. 1 is a partial view of the composition of a lid of a metallic cabinet for the housing of telecommunication system appliances provided with devices according to the invention;
Fig. 2 is an exploded view in perspective of the two terminal plates setting up a cable passing device realised according to the present invention;
Fig. 3 is an exploded view in perspective of an intermediate plate of the device according to the invention;
Fig. 4 is a partially exploded view in perspective of the composition of the multiplate device according to the invention;
Fig. 5 is a detail partially in section of device according to the invention;
Fig.s 6 and 7 are partial sections of the device according to the invention illustrating the functioning.

### Detailed description of a preferred embodiment of the invention

The following figures and description refer to a particular embodiment of the invention and their scope is purely illustrative and not limiting the ambit of protection of the present invention which might be realised by other embodiments different from the illustrated one.

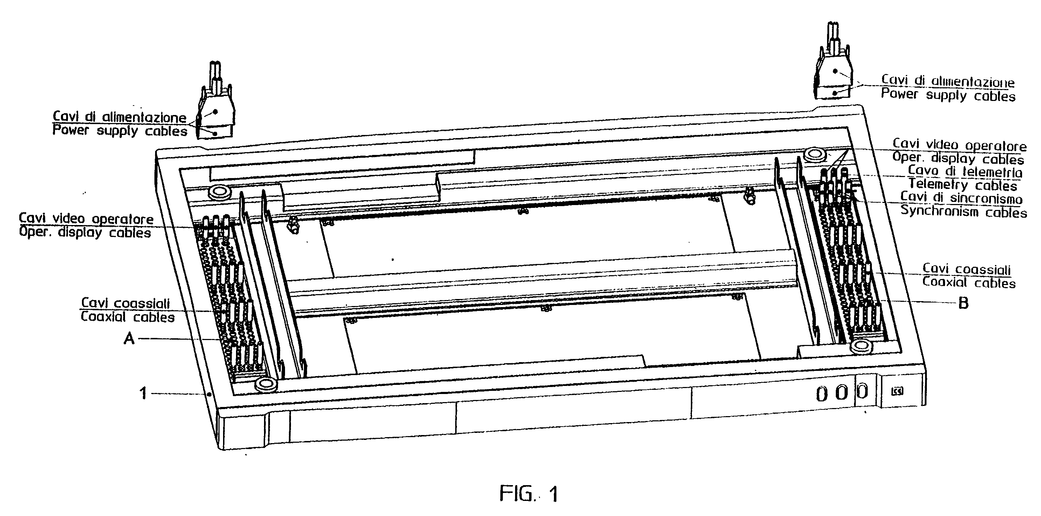

Fig. 1 shows the upper lid of a metallic cabinet inside of which appliances of a telecommunication system on which energy and signal carrying cables arriving from outside abut.

In the example illustrated in the Fig. 1, lid 1 is provided with two cable clamping devices according to the invention identified by A and B. The figure comprises labels showing some recurring typologies of cables usually connected inside of such cabinets.

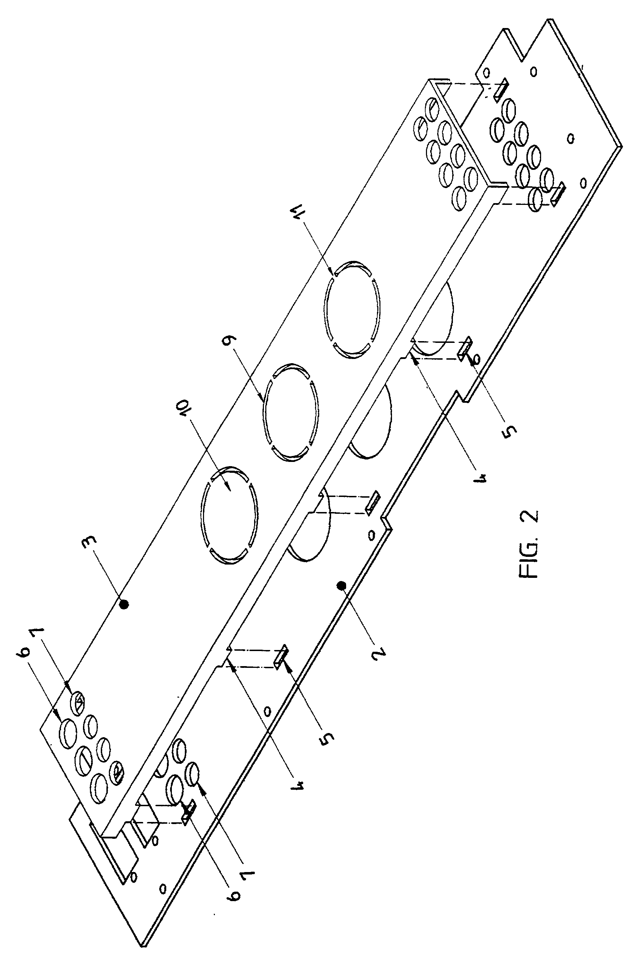

Referring to Fig. 2, each cable passing device according to the invention is set up by at least two metallic terminal plates 2 and 3, which may also be interconnected in a substantially permanent way through suitable co-operating means of alignment and mechanic connection 4 and 5, in order to set up a box-shaped body. One of the two terminal plates, in the example plate 2, will be fixed by means of screws in order to cover internally the surface of an opening in the metallic wall of the cabinet (of lid).

Both terminal plates 2 and 3 of device are provided with an identical drilling whereby the corresponding holes of the plurality of holes present in both plates 2 and 3 after their coupling turn out to be perfectly aligned or presenting coinciding axis between them.

The holes may be all of the same diameter (foreseeing passage of cables with the same diameter), but in the major part of applications there may be holes with the same diameter and different from the diameter of another group of holes. In the illustrated example the holes 9 have a larger diameter than the holes 7 which at their time have a greater diameter than the other holes 6.

By intuition it is evident that the number, the disposition, the diameter of the holes may be freely preordained in function of the type of application or of precise specifications of the number and the type of cables.

How exemplified in the figures, on the terminal plates 2 and 3 there may be also holes of great diameter, in the range of several centimetres, in that case the conductors of a shielded cable containing a large number of isolated conductors have to be abutted inside the cabinet, for example several tens of telephone duplex cables.

The plates of the device according to the invention may be predisposed with one or more of these holes with a large diameter, on the other hand functionally maintained obstructed maintaining the metallic shearing disc in seat, by means of small metallic bridges 11 according to common definition techniques for the shearing of such particulars.

Therefore the discs 10 may be only individually removed if it is necessary to use the hole for the passage of such cable with greater diameteres.

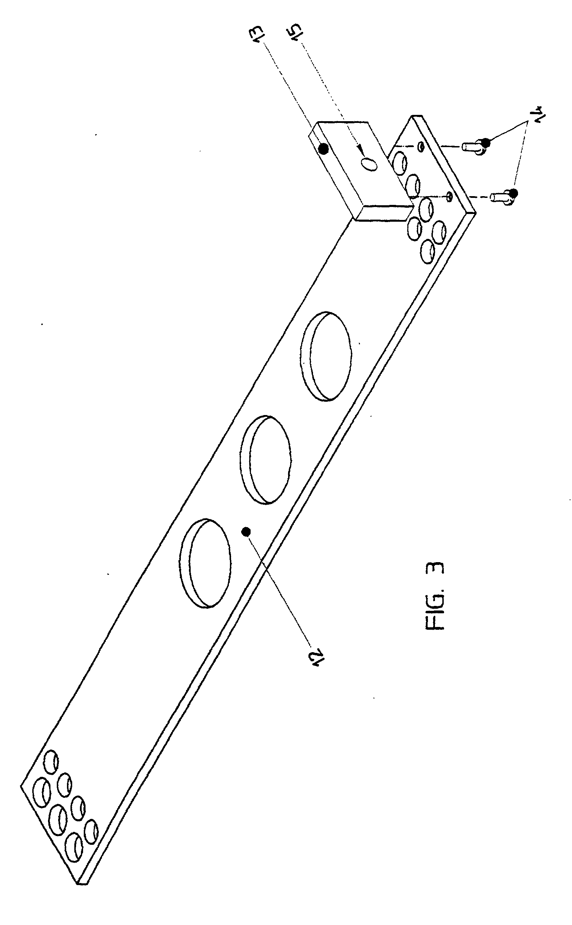

At least a third metallic plate 12, illustrated in Fig. 3 has such dimensions that it may be inserted by sliding between the 2 plates 2 and 3 constituting the box-shaped body of Fig. 2.

Also this third intermediate plate 12 is provided with a perforation, perfectly coinciding with the perforations of the others two terminal plates 2 and 3.

In the case of the intermediate plate 12, the possible presence of holes with a great diameter 9 doesn't require the preventive maintenance of the definition disc for the shearing of the same holes with a great diameter 9.
In the case of missed use of such holes with a great diameter, the electric continuity of the electromagnetic containment wall is assured just by the presence of the discs 10 in the two terminal plates 2 and 3.

In the illustrated example, the intermediate plate 12 is provided at one end of a block 13 which can be solidly connected to the late by means of studs 14 or other mechanical connecting means. Terminal block 13 is provided with a hole 15, which may be engaged by a draught organ, as it will be, illustrated hereafter in the present description.

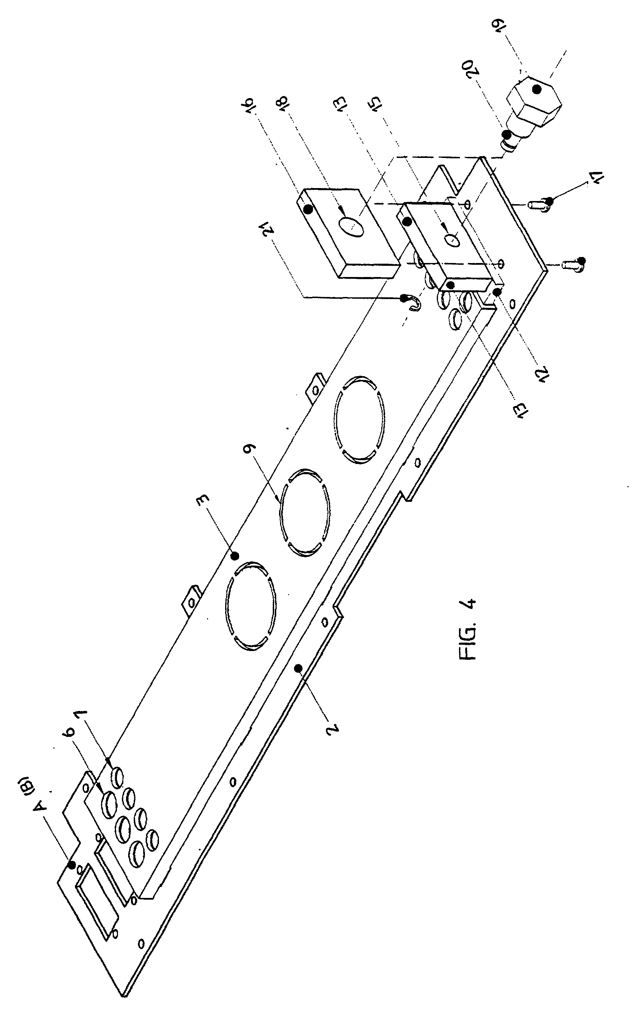

A complete view of the cable-passing device according to the invention is shown in Fig. 4.

An analogous block 16 is can be fixed by studs 17 or other mechanic coupling means to terminal plate 2, in a juxtaposed position to that of block13 fixed to the sliding intermediate plate 12. Also block16 is provided with a hole, which in this case is threaded, through which the driving screw 19 is screwed in, a tang 20 of which goes through the hole of block 13 and blocked on the other side of block 13 by an elastic washer 21 or by a split pin or another similar blocking mean.

The device is such that, rotating the screw 19 in the threaded seat 18 of block16 which is fixed to terminal plate 2, the sliding intermediate plate 12 can be moved in one or the other direction, aligning or throwing out of alignment the holes of the intermediate plate 12 with respect to the corresponding holes of the 2 terminal plates 2 and 3.

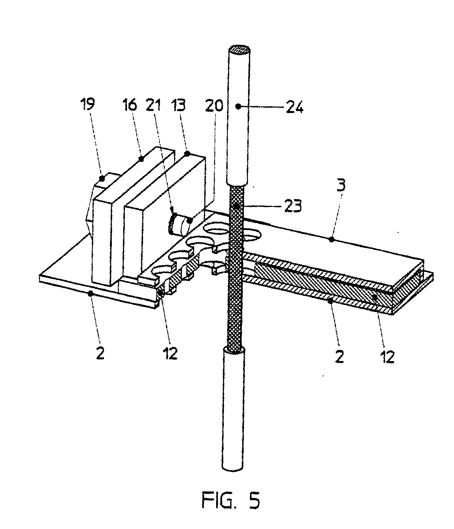

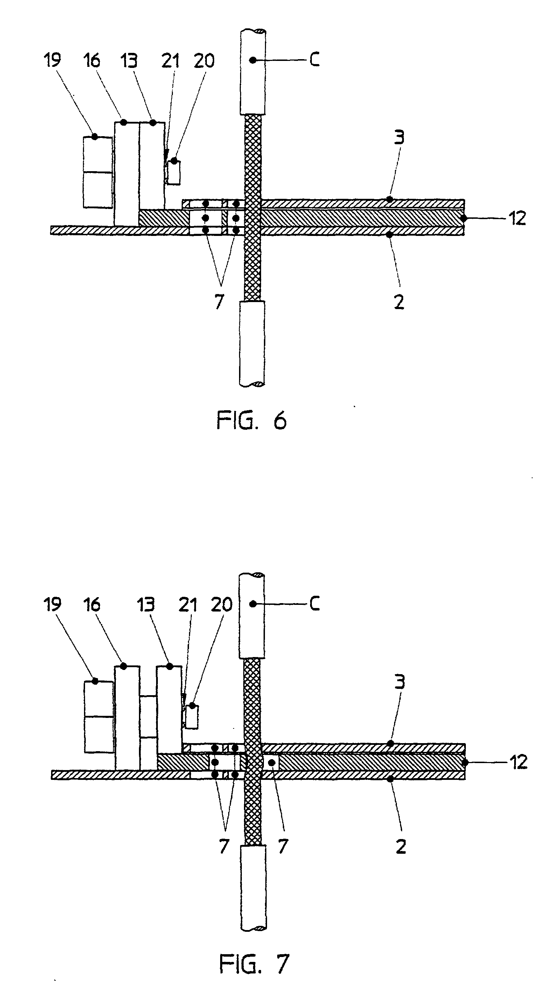

As schematically shown in Fig. 5 and Fig. 6, each cable C to abut inside the cabinet and is entered through the trio of holes of the three plates 2, 3 and 12, in the conditions of perfect alignment of the respective perforations with the part of metallic shielding braiding exhibited cutting and withdrawing a possible external isolation cladding correctly set, completing the insertion of all cables foreseen to be abutted inside the cabinet through as many holes, that is trios of aligned holes with a diameter suitable for the type of cable.
Once all the cables have been individually passed through as many holes of the device screw 19 will be screwed moving the mobile intermediate plate 12 with respect to the two terminal plates forcing with a guillotine action the edges of the respective holes always more and more thrown out of alignment among them, against the metallic shielding braiding of the cable, establishing an efficient ohm contact with it, causing also a certain deformation of the cable (either with respect to its original shape or with respect to its rectilinear layout) as it results clearly deductible from Fig. 7.

In this way, further to blocking mechanically and to contact electrically and individually in a uniform way all metallic shielding braids of the cables basically either with terminal plate 2 or with terminal plate 3, both electrically connected to the metallic wall of the cabinet of which they occlude completely a provided opening, the free space of the original loose the holes through which passes a cable as well as the free space through trios of holes where no cable passes, is reduced due to the effect of that the holes of the intermediate sliding plate 12 are thrown out of alignment.
With the exception that in the very particular case of holes with a relatively very great diameter, the normal holes predisposed for the passage of coaxial cables result partially occluded which is sufficient to make them nearly "opaque" for the passage of electromagnetic energy with a wavelength superior or equal to a certain value.
The possible presence of holes with a great diameter (9) opened because already utilised for the passage of shielded cables with a great diameter, and in a second time no more used, can be closed by means of suitable metallic caps in the holes of the two terminal plates 2 and 3.

The material or materials for the construction of carpenter stopper device according to the invention can be those commonly used for the realisation of such metallic structures of electromagnetic containment.

Stainless steels, titan, copper and other metallic alloys can be satisfactorily employed.
The thicknesses of the two terminal plates 2 and 3 and of the sliding intermediate plate 12 can be commensurate in function of type of cables taking into account the necessity to adjust the relative thicknesses of the three or more perforated plates that compose the device according to the invention as well as the finishing of the edges of the holes in order to assure, on one side, a good ohm contact with metallic shielding braids of the clamped cable and, on the other side, avoiding that the clamping function can engrave and damaging the cable.
Although a particular embodiment of the present invention has been described, it should be understood that the present invention is not limited thereto since other embodiments may be made by those skilled in the art without departing from the scope of the claims. It is thus contemplated that the present invention encompasses any and all such embodiments covered by the following claims.
For example, in the previous description reference was made to a device that comprises a first plurality of holes with such a diameter that in case said intermediate plate has been moved the maximum dimension of the waveguide individuated by the aforesaid holes which can be aligned in a mutually coaxial way among them, isn't superior to 4 mm.
It turns out to be evident to those skilled in the art that the dimension of said first plurality of holes results to be optimum for the wavelengths of the signals used in the telecommunication sector in which the applicant operates. Obviously when the appliances foreseen for the housing inside of said cabinets handle signals with a considerably different wavelength, the maximum dimension of that holes has to be modified in a suitable way, as that maximum dimension is function of the wavelength of the signals transiting in the appliances housed in that cabinets.

## Claims

1. Metallic cabinet for electromagnetic confinement of electrical equipment, a wall (1) of said cabinet being provided with an opening, cables (C, 24) having a metallic shielding braiding (23) crossing said wall through a cable clamping device (A, B) provided in said opening and establishing thereby an electrical contact between the metallic shielding braiding (23) and the metallic ground of the cabinet, said clamping device being **characterised by** at least 3 parallel electrically conducting and perforated plates with 2 fixed external plates (2, 3) and one or more intermediate plate (12) which is capable of translation with respect to the external fixed plates, all plates presenting an identical plurality of holes (6, 7, 9) for the passage of the cables (C, 24) through the respective plates (2, 3, 12) when said holes are coaxially positioned, and means (13-21) to force at least one intermediate plate (12) in a position where the axis of the holes of said intermediate plate (12) are shifted with respect to those of the external plates (2, 3).

2. Metallic cabinet according to claim 1, **characterised in that** said means to force at least one intermediate plate consist in a first block (13) fixed at one end of said intermediate plate (12) and provided with a hole (15), a second block (16) fixed to one external plate (2) and provided with a threaded hole (18), said blocks being in a juxtaposed position, one driving screw (19) screwed in the threaded hole (18) and going through said first hole (15) while being blocked at one side, so that by rotating the screw in the threaded hole, the intermediate plate is sliding.

3. Metallic cabinet according to claim 1, **characterised in that** at least one hole of the external plates is closed by an electrically conductive cap.

## Patentansprüche

1. Metallischer Schaltschrank zum elektromagnetischen Einschließen elektrischer Ausrüstungen, eine Wand (1) des genannten Schaltschrankes, versehen mit einer Öffnung, Kabel (C, 24) mit einer metallischen Abschirm-Beflechtung (23), die durch genannte Wand mittels einer Kabelklemmung-Vorrichtung (A, B) hindurchlaufen, die in genannter Öffnung vorgesehen ist und dadurch einen elektrischen Kontakt zwischen der metallischen Abschirm-Beflechtung (23) und der metallischen Erdung des Schaltschrankes herstellt, genannte Kemmvorrichtung **gekennzeichnet durch** mindestens 3 parallele, elektrisch leitende und gelochte Platten mit 2 feststehenden Außenplatten (2, 3) und eine oder mehrere Zwischenplatten (12), die sich gegenüber den festen Außenplatten verschieben können, wobei alle Platten eine gleiche Vielzahl von Löchern (6, 7, 9) für den Durchgang der Kabel (C, 24) **durch** die entsprechenden Platten (2, 3, 12) aufweisen, wenn genannte Löcher koaxial angeordnet sind, sowie Mittel (13-21), um mindestens eine Zwischenplatte (12) in eine Position zu drücken, in der die Mittellinien der Löcher der genannten Zwischenplatte (12) gegenüber denen der Außenplatten (2, 3) verschoben sind.

2. Metallischer Schaltschrank gemäß Anspruch 1, **dadurch gekennzeichnet, daß** genannte Mittel zum Drücken von mindestens einer Zwischenplatte aus einem ersten Block (13) bestehen, der an einem Ende der genannten Zwischenplatte (12) befestigt ist und mit einem Loch (15) versehen ist, sowie einem zweiten Block (16), der an einer Außenplatte (2) befestigt ist und mit einem Gewindeloch (18) versehen ist, wobei sich genannte Blöcke in einer nebeneinanderliegenden Position befinden, einer Triebschraube (19), die in das Gewindeloch (18) eingeschraubt ist und durch das genannte erste Loch (15) hindurchgeht, wobei sie auf der einen Seite verriegelt ist, so daß beim Drehen der Schraube im Gewindeloch die Zwischenplatte gleitet.

3. Metallischer Schaltschrank gemäß Anspruch 1, **dadurch gekennzeichnet, daß** mindestens ein Loch der Außenplatten durch eine elektrisch leitfähige Verschlußkappe geschlossen ist.

## Revendications

1. Armoire métallique pour confinement électromagnétique d'équipements électrique, une paroi (1) de cette armoire étant pourvue d'une ouverture, les câbles (C, 24) ayant une tresse métallique de blindage (23) passant à travers ladite paroi au moyen d'un dispositif de serrage de câbles (A, B) pourvu dans cette ouverture et établissant par cela un contact électrique entre la tresse métallique de blindage (23) et la terre métallique de l'armoire, ledit dispositif de serrage étant **caractérisé par** au moins trois plaques percées parallèles et électriquement conductrices avec deux plaques externes fixes (2, 3) et une or plusieurs plaque(s) intermédiaire(s) (12) qui son en mesure d'être mues par translation par égard aux plaques externes fixes, toutes les plaques présentant une pluralité identique de trous (6, 7, 9) pour le passage des câbles (C, 24) à travers les respectives plaques (2, 3, 12) quand ces trous sont positionnés d'une façon coaxiale, ainsi que des moyens (13-21) pour forcer au moins une plaque intermédiaire (12) jusqu'à une position où l'axe des trous de cette plaque intermédiaire (12) aura été déplacé par égard à ceux des plaques externes (2, 3).

2. Armoire métallique selon la revendication 1, **caractérisé par le fait que** lesdits moyens pour forcer au moins une plaque intermédiaire consistant en un premier bloc (13) fixé à une extrémité de ladite plaque intermédiaire (12) et pourvu d'un trou (15), un deuxième bloc (16) fixé à une plaque externe (2) et pourvu d'un trou fileté (18), lesdits blocs se trouvant juxtaposés, une vis auto taraudeuse (19) vissée dans le trou fileté et passant à travers ledit premier trou (15) pendant qu'elle vient d'être bloquée d'un côté, de façon qu'en tournant la vis dans le trou fileté, la plaque intermédiaire devient coulissante.

3. Armoire métallique selon la revendication 1, **caractérisé par le fait qu'**au moins un trou des plaques externes est obstrué par un bouchon électriquement conducteur.
